(19) Europäisches Patentamt
European Patent Office
Office européen des brevets

(11) **EP 2 490 036 B1**

(12) **EUROPÄISCHE PATENTSCHRIFT**

(45) Veröffentlichungstag und Bekanntmachung des Hinweises auf die Patenterteilung:
**28.08.2013 Patentblatt 2013/35**

(51) Int Cl.:
*G01R 33/00* (2006.01)     *G01D 3/036* (2006.01)
*G01L 1/22* (2006.01)     *G01L 5/16* (2006.01)

(21) Anmeldenummer: **12153651.0**

(22) Anmeldetag: **02.02.2012**

(54) **Stresssensor zur Erfassung mechanischer Spannungen in einem Halbleiterchip und stresskompensierter Hallsensor**

Stress sensor for measuring mechanical stresses in a semiconductor chip and stress compensated Hall sensor

Capteur de contrainte destiné à l'enregistrement de tensions mécaniques dans une puce semi-conductrice et capteur Hall à équilibrage de contrainte

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.02.2011 CH 2822011**
**21.12.2011 CH 20202011**

(43) Veröffentlichungstag der Anmeldung:
**22.08.2012 Patentblatt 2012/34**

(73) Patentinhaber: **Melexis Technologies NV**
**3980 Tessenderlo (BE)**

(72) Erfinder:
• **Schott, Christian**
**1167 Lussy-sur-Morges (CH)**
• **Huber, Samuel**
**6403 Kuessnacht am Rigi (CH)**
• **Laville, Arnaud**
**2000 Neuchatel (CH)**
• **Leten, Wouter**
**2000 Belgium (CH)**

(74) Vertreter: **Falk, Urs**
**Patentanwaltsbüro Dr. Urs Falk**
**Eichholzweg 9A**
**6312 Steinhausen (CH)**

(56) Entgegenhaltungen:
**DE-A1-102008 051 949    DE-B3-102006 045 141**
**US-A1- 2006 043 508**

**Beschreibung**

Die Erfindung betrifft einen Stresssensor zur Erfassung mechanischer Spannungen in einem Halbleiterchip und einen stresskompensierten Hallsensor.

Hallsensoren sind Magnetfeldsensoren, die auf dem Hall-Effekt basieren und ein elektrisches Ausgangssignal liefern, das proportional zu einer vorbestimmten Komponente des Magnetfeldes ist. Ein Hallsensor umfasst ein Hallelement oder ein Cluster von Hallelementen und eine elektronische Schaltung für den Betrieb der Hallelemente und die Auswertung der Ausgangssignale der Hallelemente. Der Hallsensor wird als integrierte Schaltungen hergestellt, die in einen Halbleiterchip eingebettet ist. Der Halbleiterchip ist in ein Gehäuse verpackt. Hallelemente weisen einen Offset auf, der von prozess- und geometriebedingten Abweichungen herrührt. Der Offset kann durch die Parallelschaltung von mehreren Hallelementen (Cluster) und/oder den Betrieb mit der bekannten Spinning Current Methode wirksam verringert werden. Dies ist bekannt aus einer Vielzahl von Patentdokumenten, z.B.WO 0118556, EP 548391, DE 4302342.

Der im Gehäuse verpackte Halbleiterchip ist mechanischen Spannungen ausgesetzt, die von Umwelteinflüssen wie Temperatur und Feuchtigkeit, etc. abhängen. Die wechselnden mechanischen Spannungen bewirken einerseits Veränderungen des Offsets der Hallelemente und wegen des Piezo-Hall-Effekts auch Veränderungen der Empfindlichkeit der Hallelemente. Veränderungen des Offsets werden durch die oben beschriebenen Massnahmen wirksam unterdrückt. Um die Änderungen der Empfindlichkeit zu kompensieren, ist es bekannt, beispielsweise aus DE 10154495, DE 10154498, DE 102004003853, DE 102008051949, einen Stresssensor einzusetzen, der die mechanischen Spannungen erfasst, und dessen Ausgangssignal zu verwenden, um die durch den Piezo-Hall-Effekt bewirkte Änderung der Empfindlichkeit der Hallelemente zu kompensieren.

Aus der DE 102008051949 ist ein Belastungserfassungselement bekannt, das laterale L-förmige und vertikale n-Typ Widerstände umfasst, die zu einer Wheatstone Brücke zusammengeschaltet sind. Aus der DE 102006045141 ist eine Magnetfeld-Sensor-Vorrichtung bekannt, die zwei voneinander entfernt angeordnete Magnetfeldsensoren aufweist. Bei jedem Magnetfeldsensor ist ein Stresssensor und ein Temperatursensor angeordnet. Die Stresssensoren umfassen je zwei laterale L-Widerstände. Die insgesamt vier räumlich entfernt voneinander angeordneten L-Widerstände der Stresssensoren sind zu einer Wheatstone Brücke zusammengeschaltet. Aus der US 2006043508 sind Stresssensoren bekannt, die nur n-Typ Widerstände oder nur p-Typ Widerstände oder n-Typ Widerstände und p-Typ Widerstände umfassen, die jeweils zu einer Wheatstone Brücke zusammengeschaltet sind. Die Widerstände sind entlang bevorzugter Kristallachsen ausgerichtet.

Der Erfindung liegen die Aufgaben zugrunde, auf möglichst einfache Weise die durch den Piezo-Hall-Effekt bewirkte Änderung der Empfindlichkeit eines Hallelementes zu kompensieren und einen weitgehend stresskompensierten Hallsensor zu entwickeln.

Die genannten Aufgaben werden erfindungsgemäss gelöst durch die Merkmale der unabhängigen Ansprüche 1 und 7. Vorteilhafte Ausführungen sind in den abhängigen Ansprüchen definiert.

Die Erfindung wird nachfolgend anhand von Ausführungsbeispielen und anhand der Zeichnung näher erläutert.

Fig. 1          zeigt das elektrische Schaltbild eines erfindungsgemässen, durch Widerstände gebildeten Stresssensors,

Fig. 2          illustriert die interne Struktur der Widerstände gemäss einem ersten Ausführungsbeispiel,

Fig. 3A-D       zeigen Ausführungsbeispiele der Widerstände,

Fig. 4          zeigt eine Sensorzelle, die ein Hallelement, einen p-Typ Widerstand und einen n-Typ Widerstand umfasst,

Fig. 5          zeigt zwei Sensorzellen, die einen erfindungsgemässen Stresssensor und einen Hall-Sensor bilden,

Fig. 6          zeigt eine Schaltung zum Betrieb eines Hallelementes,

Fig. 7          zeigt in Aufsicht eine Sensorzelle, die ein Hallelement, zwei n-Typ Widerstände und zwei p-Typ Widerstände umfasst,

Fig. 8 bis 11   zeigen Hallsensoren, die ein Hallelement und einen Stresssensor gemäss einem zweiten Ausführungsbeispiel der Erfindung umfassen,

Fig. 12         zeigt einen weiteren Hallsensor,

Fig. 13         zeigt einen weiteren Stresssensor gemäss der Erfindung,

Fig. 14A, B     zeigen Grundriss und Querschnitt eines Widerstandsstreifens,

Fig. 15         zeigt einen weiteren Hallsensor mit integriertem Stresssensor, und

Fig. 16 bis 18  zeigen einen Hallsensor mit mehreren integrierten Stresssensoren.

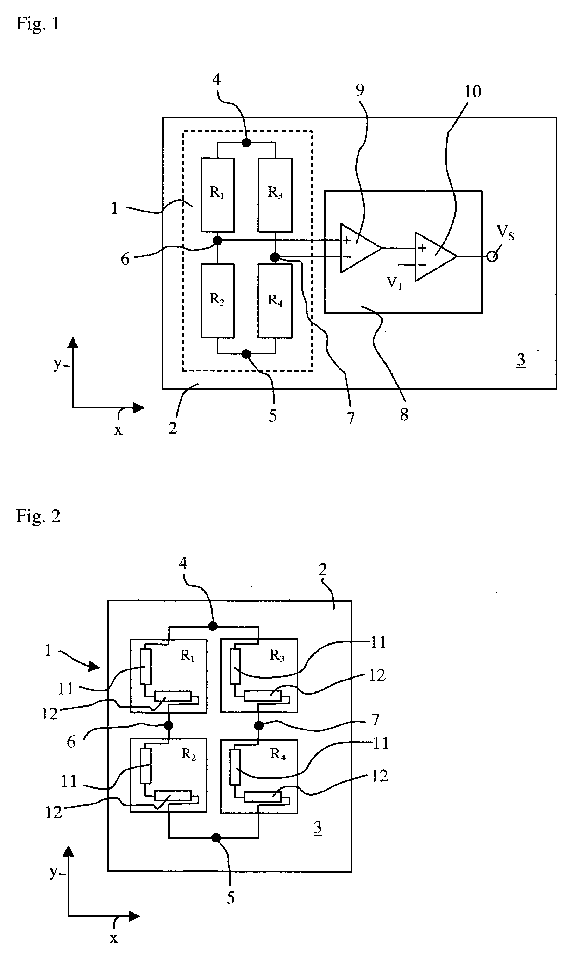

Die Fig. 1 zeigt das elektrische Schaltbild des erfindungsgemässen Stresssensors 1. Der Stresssensor 1 besteht aus einer durch vier Widerstände $R_1$, $R_2$, $R_3$ und $R_4$ gebildeten Wheatstone-Brücke, die in einen Halbleiterchip 2 integriert sind. Im folgenden bezeichnen x, y und z die Achsen eines kartesischen Koordinatensystems, wobei die z-Achse senkrecht zur aktiven Oberfläche 3 des Halbleiterchips und die x-Achse und die y-Achse parallel zu denjenigen Kanten des Halbleiterchips verläuft, die die aktive Oberfläche 3 umschliessen. Die Widerstände $R_1$ und $R_2$ sind in Reihe geschaltet, die Widerstände $R_3$ und $R_4$ sind in Reihe und parallel zu den Widerständen $R_1$ und $R_2$ geschaltet. Die Widerstände $R_1$ und $R_3$ haben einen gemeinsamen Knoten 4 und die Widerstände $R_2$ und $R_4$ haben einen gemeinsamen Knoten 5, die an eine Spannungsquelle oder eine Stromquelle anschliessbar sind. Die Widerstände $R_1$ und $R_2$ haben einen gemeinsamen Knoten 6 und die Widerstände $R_3$ und $R_4$ haben einen gemeinsamen Knoten 7, über die das Ausgangssignal $V_W$ der Wheatstone-Brücke als differenzielles Spannungssignal abgegriffen und einer Verstärkerschaltung 8 zugeführt wird.

Die Widerstände $R_1$, $R_2$, $R_3$ und $R_4$ weisen folgende Merkmale auf:

1. Die Widerstände $R_1$ und $R_4$ sind p-Typ Widerstände, d.h. im Halbleiterchip 2 integrierte Widerstände mit einer p-Typ Dotierung.
2. Die Widerstände $R_2$ und $R_3$ sind n-Typ Widerstände, d.h. im Halbleiterchip 2 integrierte Widerstände mit einer n-Typ Dotierung.

Die Widerstände $R_1$, $R_2$, $R_3$ und $R_4$ weisen zudem bevorzugt folgende Merkmale auf:

3. Die Nominalwerte der vier Widerstände $R_1$, $R_2$, $R_3$ und $R_4$ sind, abgesehen von prozessbedingten Toleranzen, gleich gross, d.h. $R_1 = R_2 = R_3 = R_4$. Dies wird erreicht durch ein den Schichtwiderständen der p-Typ Dotierung bzw. n-Typ Dotierung entsprechendes Verhältnis von Länge zu Breite der Widerstandsstreifen.
4a) Jeder der Widerstände $R_1$, $R_2$, $R_3$ und $R_4$ ist aus länglichen Widerstandsabschnitten zusammengesetzt, die direkt oder über elektrische Leiter miteinander verbunden sind und den Widerstand bilden, wobei jeder der Widerstandsabschnitte in der durch die aktive Oberfläche 3 des Halbleiterchips definierten xy-Ebene eine vorbestimmte Orientierung aufweist, wobei eine Summe der Widerstandswerte aller Widerstandsabschnitte, die eine erste Orientierung aufweisen und zum gleichen der Widerstände $R_1$, $R_2$, $R_3$ bzw. $R_4$ gehören, und eine Summe der Widerstandswerte aller Widerstandsabschnitte, die eine zweite, zur ersten um 90° gedrehte Orientierung aufweisen und ebenfalls zu diesem gleichen der Widerstände $R_1$, $R_2$, $R_3$ bzw. $R_4$ gehören, den gleichen nominalen Wert haben. oder
4b) Die n-Typ Widerstände $R_2$ und $R_3$ sind ausgebildet wie beim Merkmal 4a, die p-Typ Widerstände $R_1$ und $R_4$ sind längliche Widerstandsstreifen, die gegenüber den Kanten des Halbleiterchips um 45° oder -45° gedreht sind. oder
4c) Die vier Widerstände $R_1$, $R_2$, $R_3$ und $R_4$ sind längliche Widerstandsstreifen, die gegenüber den Kanten des Halbleiterchips um 45° oder -45° gedreht sind.
5a) Die für die Widerstände $R_1$, $R_2$, $R_3$ und $R_4$ verwendeten Dotierungen sind vorzugsweise die für die Herstellung der Kontakte verwendeten hoch dotierten $N^+$ bzw. $P^+$ Dotierungen. oder
5b) Die n-Typ Widerstände $R_2$ und $R_3$ bestehen aus hoch dotiertem $N^+$ und vergleichsweise niedriger dotiertem N Material. Die p-Typ Widerstände $R_2$ und $R_3$ bestehen aus hoch dotiertem $P^+$ Material. oder
5c) Die n-Typ Widerstände $R_2$ und $R_3$ bestehen aus hoch dotiertem $N^+$ und vergleichsweise niedriger dotiertem N Material. Die p-Typ Widerstände $R_1$ und $R_4$ bestehen aus hoch dotiertem $P^+$ und vergleichsweise niedriger dotiertem P Material.
6. Die in den Widerstandsabschnitten fliessenden Ströme fliessen im wesentlich parallel zur aktiven Oberfläche 3 des Halbleiterchips 2. Die Widerstände $R_1$, $R_2$, $R_3$ und $R_4$ können deshalb als laterale Widerstände bezeichnet werden.

Die Wheatstone-Brücke befindet sich typischerweise im Bulk-Material des Halbleiterchips, sie kann bei gewissen Anwendungen aber auch in eine beliebige Mikrostruktur eines Mikrosensors integriert sein, wie zum Beispiel frei liegende Biegebalken und Membranen. Sie wird über die Knoten 4 und 5 mit einem Strom oder einer Spannung beaufschlagt.

Die Fig. 2 illustriert die interne Struktur der Widerstände $R_1$, $R_2$, $R_3$ und $R_4$ gemäss einem ersten Ausführungsbeispiel des erfindungsgemässen Stresssensors, bei dem die Widerstände $R_1$, $R_2$, $R_3$ und $R_4$ gemäss den Merkmalen 1, 2, 3, 4a, 5 und 6 ausgebildet sind. Die Widerstände $R_1$, $R_2$, $R_3$ und $R_4$ weisen je mindestens zwei längliche Widerstandsstreifen 11 und 12 auf, die den gleichen nominalen Widerstandswert aufweisen, zueinander um 90° verdreht und in Reihe geschaltet sind. Im Beispiel sind die vier Widerstandsstreifen 11 parallel zur y-Achse und die vier Widerstandsstreifen 12 parallel zur x-Achse ausgerichtet. Die Widerstandsstreifen 11 und 12 können jedoch innerhalb der durch die x- und die y-Achse aufgespannten Ebene um einen beliebigen Winkel gedreht werden, wichtig ist einzig, dass ihre aufeinander bezogene, relative Drehlage erhalten bleibt, d.h. dass sie in der xy-Ebene liegen und einen Winkel von 90° einschliessen. Bei dem in der Fig. 2 gezeigten Ausführungsbeispiel sind die Widerstandsstreifen 11 und 12 jedes der Widerstände $R_1$, $R_2$, $R_3$ und $R_4$ zwei einzelne, voneinander getrennte Widerstandsstreifen, die durch einen elektrischen Leiter miteinander verbunden sind und so zusammen den entsprechenden Widerstand $R_1$, $R_2$, $R_3$ bzw. $R_4$ ergeben.

Der in Merkmal 4a angegebene Grundsatz lässt sich am einfachsten realisieren durch ein Paar von länglichen Widerstandsstreifen, wobei die beiden Widerstandsstreifen des Paares in der xy-Ebene des Halbleiterchips 2 um 90° gedreht zueinander angeordnet und in Reihe geschaltet sind, so wie dies in der

Fig. 2 dargestellt ist. D.h. die beiden Widerstandsstreifen eines Paares bilden zusammen einen L-förmigen Widerstand.

Für Standard (100) Silizium mit einer <110> Orientierung des Flats ist die Abhängigkeit der Widerstandswerte vom Stress annähernd durch folgende Gleichungen gegeben:

$$\Delta Rn/Rn = -24\%/GPa*(Txx +Tyy) + 53\%/GPa*Tzz \tag{1}$$

$$\Delta Rp/Rp = 2.7\%/GPa*(Txx +Tyy) - 1.1\%/GPa*Tzz \tag{2},$$

wobei Txx, Tyy und Tzz die drei in Richtung der x-Achse bzw. y-Achse bzw. z-Achse gerichteten Normalspannungskomponenten des mechanischen Spannungstensors bezeichnen. Die angegebenen Prozentzahlen (24%, 53%, 2.7% und 1.1%) sind als Näherungswerte bei niedriger Dotierung zu verstehen und bei (100) Silizium unabhängig von der Drehlage des Siliziumwafers.

Weil Tzz in der Praxis meistens viel kleiner als Txx und Tyy ist, gilt angenähert

$$\Delta Rn/Rn = -24\%/GPa*(Txx +Tyy) \tag{3}$$

$$\Delta Rp/Rp = 2.7\%/GPa*(Txx +Tyy) \tag{4}.$$

Die durch mechanische Belastungen bewirkte Änderung der Widerstandswerte der n-Typ Widerstände ist einerseits um etwa eine Grössenordnung (hier etwa um den Faktor 9) grösser als die Änderung der Widerstandswerte der p-Typ Widerstände. Die unterschiedliche Grösse ist eine Voraussetzung, dass die durch die Widerstände $R_1$ bis $R_4$ gebildete Wheatstone Brücke überhaupt ein Ausgangssignal liefert. Das Ausgangssignal $V_w$ der Wheatstone Brücke ist proportional zur Summe Txx + Tyy. Andererseits haben die n-Typ Widerstände $R_2$ und $R_3$ etwa ähnliche Temperaturkoeffizienten wie die p-Typ Widerstände $R_1$ und $R_4$, mit der Folge, dass das Ausgangssignal $V_w$ der Wheatstone Brücke durch Temperaturänderungen nur wenig beeinflusst wird. Die Temperaturkoeffizienten der hoch dotierten $N^+$ bzw. $P^+$ Widerstände sind bei dem verwendeten CMOS-Prozess um etwa den Faktor 2.5 geringer als die Temperaturkoeffizienten der weniger stark dotierten n-Wannen bzw. p-Wannen. Dies ist der Grund, weshalb für die Widerstände bevorzugt die hoch dotierten $N^+$ bzw. $P^+$ Dotierungen verwendet werden.

Das differenzielle Ausgangssignal $V_W$ der Wheatstone Brücke wird der Verstärkerschaltung 8 (Fig. 1) zugeführt, wo es beispielsweise mittels eines ersten Operationsverstärkers 9 in ein Differenzsignal umgewandelt und mittels eines zweiten Operationsverstärkers 10 durch Subtraktion eines konstanten Werts $V_1$ offsetkompensiert wird und dann als Ausgangssignal $V_S$ des Stresssensors 1 zur Verfügung steht.

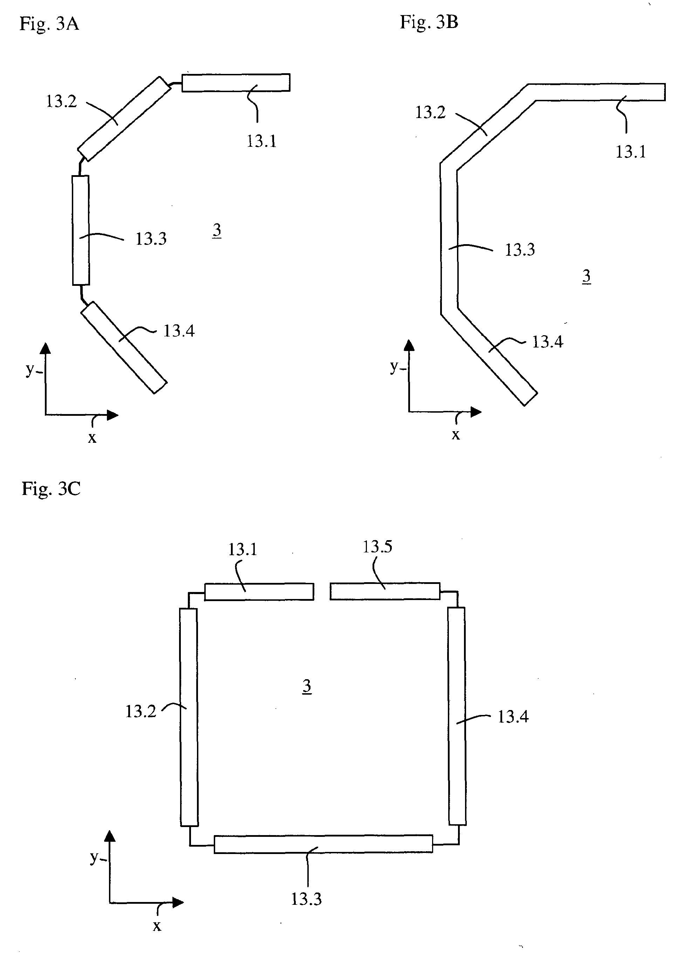

Die Fig. 3A zeigt in Aufsicht auf die aktive Oberfläche 3 des Halbleiterchips 2 ein Ausführungsbeispiel eines der Widerstände $R_1$, $R_2$, $R_3$ und $R_4$. Der Widerstand ist aus mehreren länglichen Widerstandsabschnitten 13.1 bis 13.4 zusammengesetzt, wobei jeweils zwei Widerstandsabschnitte 13, von denen der eine Widerstandsabschnitt 13 in Bezug auf den anderen Widerstandsabschnitt 13 in der xy-Ebene um 90° gedreht ist, den gleichen nominalen Widerstandswert haben und ein Paar bilden. Hier gibt es zwei Paare: Das erste Paar bilden die Widerstandsabschnitte 13.1 und 13.3, das zweite Paar bilden die Widerstandsabschnitte 13.2 und 13.4. Der Widerstandsabschnitt 13.2 ist gegenüber dem Widerstandsabschnitt 13.1 um den Winkel 45° gedreht. Der Widerstandsabschnitt 13.4 ist gegenüber dem Widerstandsabschnitt 13.1 um den Winkel 45° gedreht. Die Widerstandsabschnitte 13.1 bis 13.4 können wie dargestellt durch elektrische Leiter miteinander in Reihe geschaltet sein. In diesem Fall können sich die Widerstandsabschnitte an beliebigen und unterschiedlichen Orten auf dem Halbleiterchip 2 befinden. Die Widerstandsabschnitte 13.1 bis 13.4 können aber auch wie in der Fig. 3B dargestellt direkt miteinander verbunden sein und einen einzigen zusammenhängenden Widerstandsstreifen bilden.

Die Fig. 3C zeigt ein weiteres Ausführungsbeispiel eines der Widerstände $R_1$, $R_2$, $R_3$ und $R_4$. Der Widerstand ist aus fünf länglichen Widerstandsabschnitten 13.1 bis 13.5 zusammengesetzt. Die Widerstandsabschnitte 13.2, 13.3 und 13.4 haben den gleichen nominalen Widerstandswert, R. Die Widerstandsabschnitte 13.1 und 13.5 haben den halben Widerstandswert R/2, sie sind deshalb als ein gemeinsamer Widerstandabschnitt mit dem nominalen Widerstandswert R anzusehen, der geometrisch in zwei Teile aufgespalten ist. Die Summe der Widerstandswerte der Widerstandsabschnitte 13.1, 13.3 und 13.5, die eine gleiche, erste Orientierung haben, beträgt 2*R und ist gleich der Summe der Widerstandswerte der Widerstandsabschnitte 13.2 und 13.4, die eine gleiche, zweite Orientierung haben, wobei die erste und zweite Orientierung in der durch die aktive Oberfläche 3 des Halbleiterchips 2 definierten xy-Ebene zueinander um 90° gedreht sind.

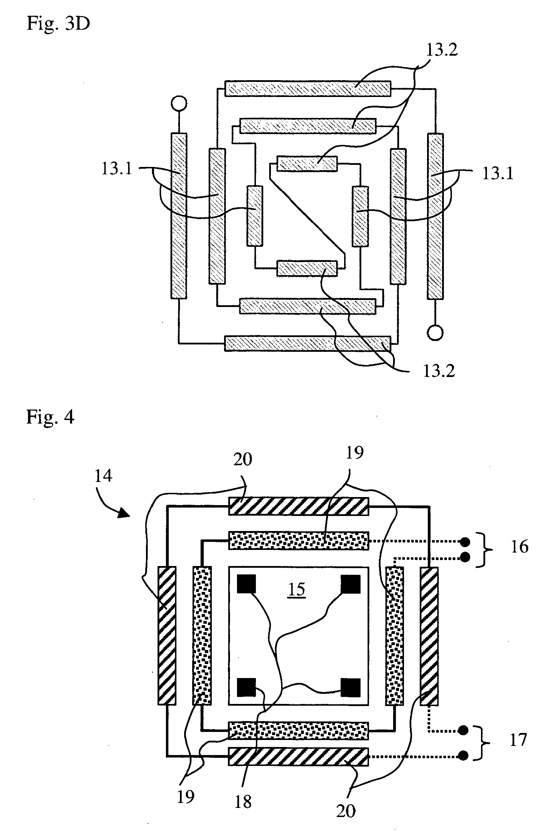

Die Fig. 3D zeigt ein weiteres Ausführungsbeispiel eines der Widerstände $R_1$, $R_2$, $R_3$ und $R_4$. Der Widerstand ist aus länglichen Widerstandsabschnitten 13.1 und 13.2 zusammengesetzt, deren Längsachse entweder parallel zu einer ersten Richtung oder parallel zu einer zweiten, zur ersten orthogonalen Richtung verläuft. Die Summe der Widerstandswerte der Widerstandsabschnitte 13.1, die parallel zur ersten Richtung ausgerichtet sind, ist gleich der Summe der Widerstandswerte der Widerstandsabschnitte 13.2, die parallel zur zweiten Richtung ausgerichtet sind. Im Prinzip ist jedem Widerstandsabschnitt 13.1, der parallel zur ersten Richtung ausgerichtet ist, ein Widerstandsabschnitt 13.2 zugeordnet, der parallel zur zweiten Richtung ausgerichtet ist. Die Widerstandsabschnitte 13.1 und 13.2 sind so nahe beieinander angeordnet, wie es die Technologie erlaubt. In der Zeichnung ist dies aus Gründen der Klarheit nicht der Fall. Diese Anordnung der Widerstandsabschnitte 13.1 und 13.2 ergibt einen kompakten Widerstand, der eine kleine Fläche belegt und eine vergleichsweise geringe Streuung zwischen der Summe der Widerstandswerte der Widerstandsabschnitte 13.1 und der Summe der Widerstandswerte der Widerstandsabschnitte 13.2 aufweist.

Das Verhältnis von Länge zu Breite der Widerstandsabschnitte, die dem gleichen Paar zuzuordnen sind, ist im Grundsatz so bemessen, dass eine mechanische Belastung durch die Normalspannungskomponente Txx eine gleich grosse Änderung des durch die Widerstandsabschnitte gebildeten Widerstands bewirkt wie eine mechanische Belastung durch die Normalspannungskomponente Tyy.

Der erfindungsgemässe Stresssensor eignet sich beispielsweise, um bei einem auf dem Hall-Effekt basierenden Magnetfeldsensor die durch den Piezo-Hall Effekt verursachte Änderung der Empfindlichkeit zu kompensieren. Die Fig. 4 zeigt in Aufsicht eine Sensorzelle 14, die ein Hallelement 15, einen n-Typ Widerstand 16 und einen p-Typ Widerstand 17 umfasst. Das Hallelement 15 ist bei diesem Beispiel eine quadratische n-Wanne (oder eine p-Wanne) und die vier Kontakte 18 für die Zuführung des Hallstroms und den Abgriff der Hallspannung sind in den Ecken des Quadrats angeordnet. Der n-Typ Widerstand 16 ist durch vier gerade n-Typ Widerstandsbahnen 19 gebildet, die parallel zu den vier Seiten der quadratischen n-Wanne ausgerichtet und durch elektrische Leiterbahnen miteinander verbunden sind. Je zwei der vier n-Typ Widerstandsbahnen 19 verlaufen somit parallel zur x-Achse und zur y-Achse. Der p-Typ Widerstand 17 ist durch vier gerade p-Typ Widerstandsbahnen 20 gebildet, die parallel zu den Seiten des Quadrats ausgerichtet und durch elektrische Leiterbahnen miteinander verbunden sind. Je zwei der vier p-Typ Widerstandsbahnen 20 verlaufen somit parallel zur x-Achse und zur y-Achse. Das Layout der einzelnen Elemente der Sensorzelle 14 ist mit einer möglichst hohen Symmetrie ausgeführt, so dass mechanische Belastungen sich möglichst gleichmässig über die Sensorzelle 14 verteilen.

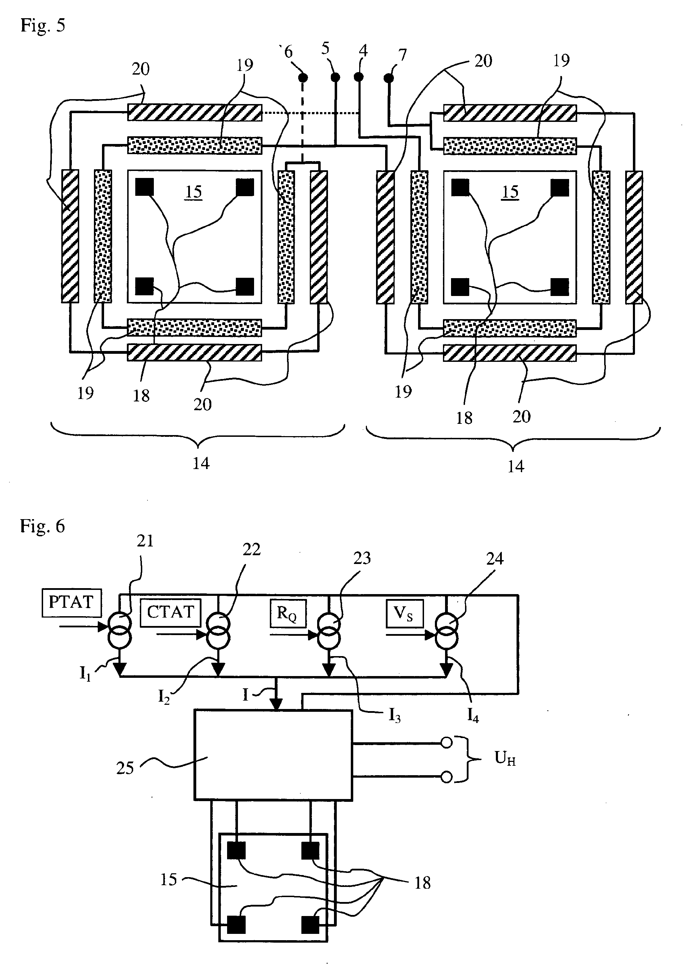

Die Fig. 5 zeigt in Aufsicht zwei Sensorzellen 14 des in der Fig. 4 gezeigten Typs. Die beiden n-Typ Widerstände 16 und die beiden p-Typ Widerstände 17 der beiden Sensorzellen 14 sind gemäss dem in der Fig. 1 gezeigten elektrischen Schaltbild als Wheatstone-Brücke verdrahtet und bilden einen erfindungsgemässen Stresssensor. Zur Darstellung der Verdrahtung werden aus Gründen der zeichnerischen Klarheit verschiedenartige Linien, nämlich ausgezogene, gestrichene und punktierte Linien verwendet. Die beiden Hallelemente 15 bilden zusammen mit der für ihren Betrieb nötigen elektronischen Schaltung einen Hall-Sensor. Das differenzielle Ausgangssignal $V_w$ der Wheatstone Brücke wird einer Verstärkerschaltung 8 zugeführt, beispielsweise der in der Fig. 1 erläuterten Verstärkerschaltung 8, wo es verstärkt und der Offset der Wheatstone Brücke soweit als möglich eliminiert wird, so dass das Ausgangssignal $V_s$ des Stresssensors als offsetkompensiertes Ausgangssignal zur Verfügung steht.

Die Fig. 6 zeigt ein bevorzugtes Ausführungsbeispiel, wie das Ausgangssignal $V_s$ des in der Fig. 5 gezeigten Stresssensors verwendet wird, um die durch den Piezo-Hall Effekt bewirkte Änderung der magnetfeldbezogenen Empfindlichkeit der beiden Hallelemente 15, zu kompensieren. Die durch den Piezo-Halleffekt bewirkte Änderung der Empfindlichkeit der beiden Hallelemente 15 ist in erster Näherung proportional zur Summe Txx + Tyy der in die x-Richtung und die y-Richtung wirkenden mechanischen Belastungen.

Die beiden Hallelemente 15 werden mit Vorteil in bekannter Weise durch Parallelschaltung und Betrieb mit der Spinning Current Methode offsetkompensiert (siehe z. B. EP 548391). Die beiden Hallelemente 15 werden dabei getrennt voneinander mit der Spinning Current Methode betrieben, wobei jedes von einer eigenen Konstantstromquelle gespeist wird, und dann ihre Ausgangssignale addiert. Die Fig. 6 zeigt deshalb nur das elektrische Schaltschema der elektronischen Schaltung für ein Hallelement 15. Die elektronische Schaltung umfasst in diesem Beispiel vier Stromquellen 21 bis 24, deren Ströme addiert und/oder subtrahiert und dem Hallelement 15 als Strom I über einen Spinning Current Multiplexer 25 zugeführt werden. Die am Ausgang des Multiplexers anliegende Hallspannung ist eine Wechselspannung, die in bekannter Weise verarbeitet und ausgewertet werden kann.

Die erste Stromquelle 21 ist eine PTAT Konstantstromquelle (PTAT = proportional to absolute temperature) und liefert einen Strom $I_1$, der proportional zur absoluten Temperatur ist. Die zweite Stromquelle 22 ist eine CTAT Konstantstromquelle (CTAT = complementary to absolute temperature) und liefert einen Strom $I_2$, der mit zunehmender Temperatur abnimmt. Die dritte Stromquelle 23 wird von einem temperaturunabhängigen Widerstand $R_Q$ gesteuert und liefert einen von der Temperatur unabhängigen Strom $I_3$. Die vierte Stromquelle 24 wird vom Ausgangssignal $V_s$ des Stresssensors 1 gesteuert und liefert einen Strom $I_4$, der proportional zur Summe (Txx + Tyy) ist.

$$I_1 = I_P * [\, 1 + a * (T - T_0) \,]$$

$$I_2 = I_C * [\, 1 - b * (T - T_0) \,]$$

$$I_3 = I_R$$

$$I_4 = c * V_S$$

wobei $T_0$ eine ausgewählte fixe Temperatur ist und a und b durch die Eigenschaften der PTAT und CTAT Konstantstromquellen vorgegebene Parameter sind. $I_P$, $I_C$, $I_R$ und c sind wählbare Parameter, die so aufeinander abgestimmt sind, dass die Summe der Ströme $I_1$ bis $I_4$ innerhalb eines bestimmten Temperaturbereiches folgendes Verhalten hat:

$$I = I_1 + I_2 + I_3 + I_4 = I_0 * [\, 1 + \delta * (T - T_0) + \lambda * V_S] \qquad (5)$$

Die Koeffizienten $\delta$ und $\lambda$ sind Konstanten, $I_0$ bezeichnet den bei der Temperatur $T_0$ und bei Abwesenheit von mechanischen Belastungen von den Stromquellen 21 bis 24 gelieferten Strom.

Der Temperaturbereich, in dem das Hallelement 15 eingesetzt werden soll, ist typischerweise in mehrere, z.B. drei, Temperaturbereiche unterteilt, in denen die Parameter $I_P$, $I_C$, $I_R$, c und $T_0$ so gewählt sind, dass in jedem einzelnen Temperaturbereich durch den Strom I einerseits die lineare Abhängigkeit der strombezogenen Empfindlichkeit des Hallelementes als auch die lineare Abhängigkeit des Ausgangssignals $V_S$ des Stresssensors von der Temperatur und andererseits die Abhängigkeit der strombezogenen Empfindlichkeit des Hallelementes von mechanischen Belastungen kompensiert wird, und dass über alle Temperaturbereiche auch die quadratische Abhängigkeit der strombezogenen Empfindlichkeit des Hallelementes und die quadratische Abhängigkeit des Ausgangssignals $V_S$ des Stresssensors von der Temperatur kompensiert werden, so dass die vom Hallelement 15 gelieferte Hallspannung $U_H$ weitgehend unabhängig von der Temperatur T und von mechanischen Belastungen Txx und Tyy ist. Für (100) Silizium mit <110> Flat ergibt sich der Strom

$$I = I_0 * [\, 1 + \delta * (T - 25°C) + \varepsilon * (T - 25°C)^2 + \lambda * V_S] \qquad (6)$$

wobei die Konstanten $\delta$, $\varepsilon$ und $\lambda$ in einem experimentellen Beispiel folgende Werte hatten:

$$\delta = 300 \text{ ppm/°C}$$

$$\varepsilon = 5 \text{ ppm/°C}^2$$

$$\lambda = 2.2/\text{V}$$

Es ist aus Gründen der Offsetkompensation bekanntermassen vorteilhaft, zwei oder mehr Hallelemente parallel und zudem mit der Spinning Current Methode zu betreiben und ihre Hallspannungen vorzeichenrichtig zu addieren. Die beiden Hallelemente 15 des in der Fig. 5 gezeigten Hall-Sensors sind zusammen von zwei n-Typ Widerständen 16 und zwei p-Typ Widerständen 17 umgeben, die zusammen die Wheatstone Brücke des Stresssensors 1 bilden. Wenn der Hall-Sensor vier Hallelemente 15 umfasst, dann ist es vorteilhaft, den Hall-Sensor und den Stresssensor 1 weiterhin aus Sensorzellen 14 des in der Fig. 4 gezeigten Typs zu bilden. Da die Wheatstone Brücke des Stresssensors 1 nur vier Widerstände benötigt, kann sie beispielsweise gebildet werden, indem je zwei n-Typ Widerstände 16 und zwei p-Typ Widerstände 17 der insgesamt acht Widerstände ausgewählt werden und die anderen vier Widerstände nicht benutzt werden. Alternativ können alle acht Widerstände der vier Sensorzellen 14 benutzt werden, indem je zwei Widerstände des gleichen Typs in Reihe oder parallel geschaltet und daraus die Wheatstone Brücke des Stresssensors 1 gebildet werden. Eine andere Möglichkeit ist, zwei Typen von Sensorzellen vorzusehen, wobei der erste Typ ein Hallelement und einen das Hallelement umgebenden n-Typ Widerstand und der zweite Typ ein Hallelement und einen das Hallelement umgebenden p-Typ Widerstand umfasst.

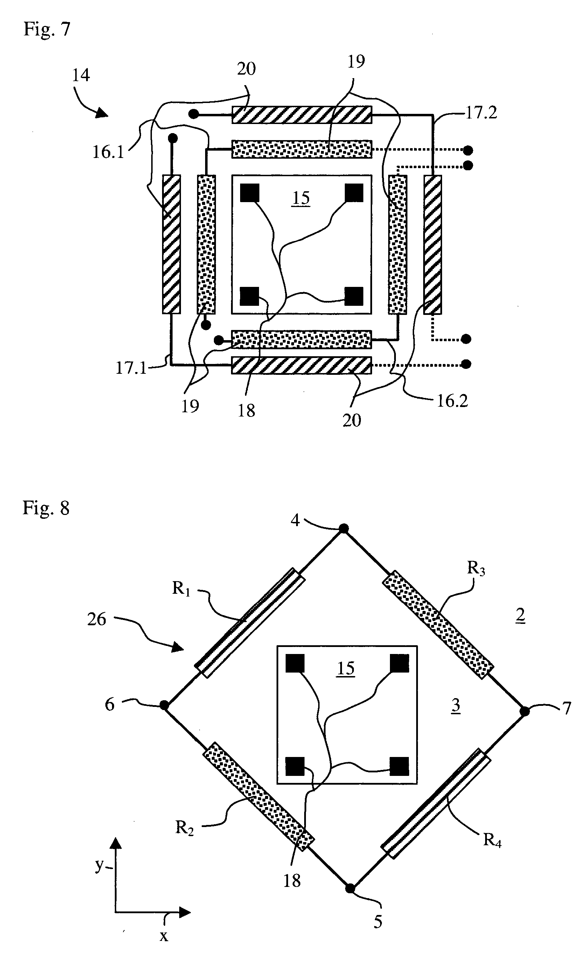

Die Fig. 7 zeigt in Aufsicht eine Sensorzelle 14, die ein Hallelement 15, zwei n-Typ Widerstände 16.1 und 16.2 und zwei p-Typ Widerstände 17.1 und 17.2 umfasst. Die n-Typ Widerstände 16.1 und 16.2 sind durch je zwei gerade, um 90° zueinander verdreht angeordnete n-Typ Widerstandsbahnen 19 gebildet, die parallel zu den Seiten der quadratischen Wanne des Hallelementes 15 ausgerichtet und durch elektrische Leiterbahnen miteinander verbunden sind. Die p-Typ Widerstände 17.1 und 17.2 sind durch je zwei gerade, um 90° zueinander verdreht angeordnete p-Typ Widerstandsbahnen 20 gebildet, die parallel zu den Seiten der quadratischen Wanne des Hallelementes 15 ausgerichtet und durch elektrische Leiterbahnen miteinander verbunden sind. Diese Sensorzelle 14 enthält somit zwei n-Typ und zwei p-Typ Widerstände, die alle für die Bildung eines erfindungsgemässen Stresssensors 1 erforderlichen Eigenschaften aufweisen, und ein Hallelement und stellt somit das einfachste Beispiel dar, um einen beispielsweise gemäss dem in der Fig. 6 gezeigten Schaltschema weitgehend temperatur- und stresskompensierten Magnetfeldsensor zu bilden.

Die Fig. 8 bis 11 zeigen weitere Hallsensoren, die ein Hallelement 15 (oder einen Cluster aus Hallelementen) und einen erfindungsgemässen Stresssensor 26 umfassen. Der Stresssensor 26 besteht wiederum aus einer durch vier Widerstände $R_1$, $R_2$, $R_3$ und $R_4$ gebildeten Wheatstone-Brücke, die in einen Halbleiterchip 2 integriert sind. Die Widerstände $R_1$ und $R_2$ sind in Reihe geschaltet, die Widerstände $R_3$ und $R_4$ sind in Reihe und parallel zu den Widerständen $R_1$ und $R_2$ geschaltet. Die Widerstände $R_1$ und $R_3$ haben einen gemeinsamen Knoten 4 und die Widerstände $R_2$ und $R_4$ haben einen gemeinsamen Knoten 5, die an eine Spannungsquelle oder eine Stromquelle anschliessbar sind. Die Widerstände $R_1$ und $R_2$ haben einen gemeinsamen Knoten 6 und die Widerstände $R_3$ und $R_4$ haben einen gemeinsamen Knoten 7, über die das Ausgangssignal der Wheatstone-Brücke als differenzielles Spannungssignal abgegriffen und einer Verstärkerschaltung zugeführt wird. Die Widerstände $R_1$ und $R_4$ sind p-Typ Widerstände, die Widerstände $R_2$ und $R_3$ sind n-Typ Widerstände.

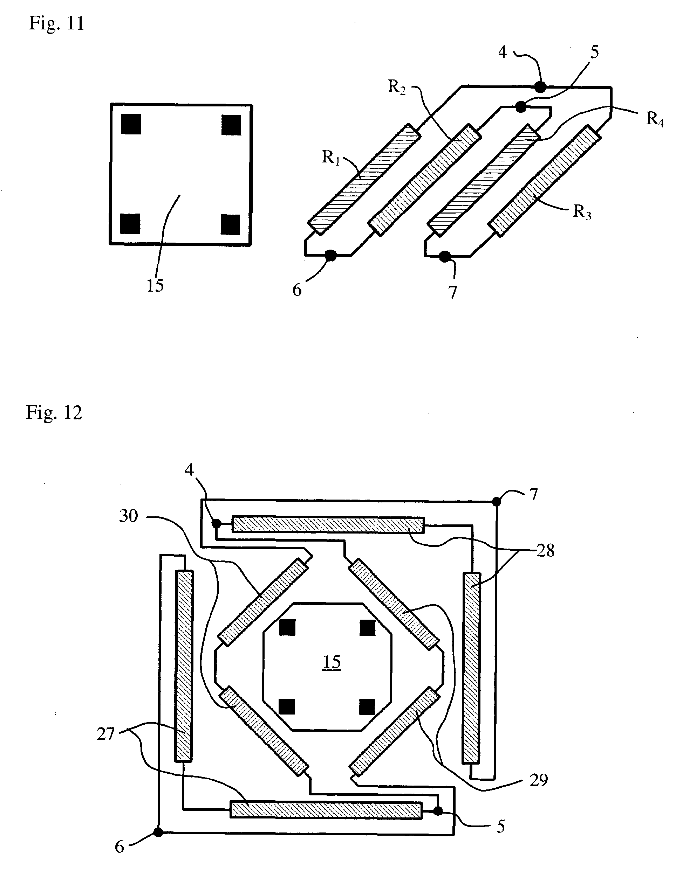

Wenn man ausgehend von der in der Fig. 2 gezeigten Struktur der Widerstände $R_1$, $R_2$, $R_3$ und $R_4$ eine Vielzahl von Paaren von kurzen Widerstandsstreifen 11 und 12 aneinanderreiht, erhält man einen treppenförmigen Widerstand und wenn man die Widerstandsstreifen 11 und 12 im Limes unendlich kurz macht, erhält man einen bezüglich der x-Achse um 45° oder -45° gedrehten, länglichen Widerstand. Die in den Fig. 8 bis 11 gezeigten Widerstände $R_1$, $R_2$, $R_3$ und $R_4$ des Stresssensors 26 sind somit gemäss einem zweiten Ausführungsbeispiel gemäss dem Merkmal 4c ausgebildet. Bei dem in der Fig. 11 gezeigten Ausführungsbeispiel des Hallsensors sind die Widerstände $R_1$, $R_2$, $R_3$ und $R_4$ neben dem Hallelement 15 und nebeneinander angeordnet, um eine möglichst geringe Diskrepanz (engl. mismatch) der Widerstände $R_1$, $R_2$, $R_3$ und $R_4$ zu erreichen. Entscheidend ist bei diesen Ausführungsbeispielen, dass wie oben erwähnt die Kanten des Halbleiterchips parallel zu der x-Achse bzw. y-Achse verlaufen.

Der Stresssensor 26 und das Hallelement 15 (bzw. ein Cluster aus Hallelementen) lassen sich bei Verwendung von (100) Silizium mit <110> Flat zu einem optimal stresskompensierten Hallsensor kombinieren, wenn die folgenden Bedingungen erfüllt sind:

-    Die Widerstände $R_1$, $R_2$, $R_3$ und $R_4$ sind längliche Widerstände, die bezüglich der <110> Kristallrichtung des Siliziums um 45° oder -45° gedreht sind (die in den Figuren gezeigte x-Achse verläuft parallel zur <110> Kristallrichtung).
-    Das Hallelement 15 (bzw. die Hallelemente eines Clusters) weist wenigstens vier Kontakte auf, die so ausgerichtet sind, dass bei Beaufschlagung von zwei dieser vier Kontakte mit einem Strom der Strom unter einem Winkel von 45° oder -45° schräg zur <110> Kristallrichtung durch das Hallelement 15 fliesst.

Da die Kanten des Halbleiterchips parallel und orthogonal zum Flat verlaufen, sind die Widerstände $R_1$, $R_2$, $R_3$ und $R_4$ bezüglich den Kanten des Halbleiterchips um 45° oder -45° gedreht.

Das Ausgangssignal $V_w$ der Wheatstone Brücke steuert eine Stromquelle, deren Strom dem Hallelement 15 wie bei den vorhergehenden Beispielen zugeführt wird, um den Einfluss von mechanischen Belastungen zu verringern.

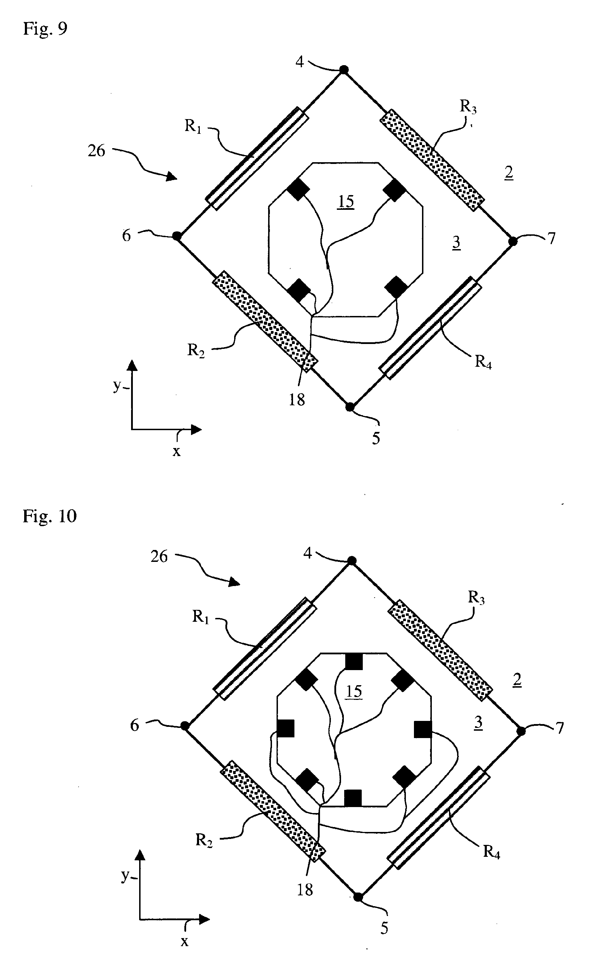

Das in der Fig. 10 gezeigte Hallelement 15 hat einen octagonalen Umriss mit acht gleich langen Seiten und acht Kontakten 18, wobei in jeder Betriebsphase der Spinning Current Methode jeweils zwei einander diametral gegenüberliegenden Kontakte als Stromkontakte und zwei weitere dazu um 90° gedreht angeordnete, einander diametral gegenüberliegende Kontakte als Spannungskontakte dienen. Hier fliesst der Strom in den einzelnen Betriebsphasen jeweils unter einem Winkel von 0°, 45°, -45° oder 90° zur <110> Kristallrichtung.

Die Fig. 12 zeigt ein weiteres Ausführungsbeispiel eines Hallsensors, der einen erfindungsgemässen Stresssensor und ein Hallelement 15 umfasst. Das Grundmaterial ist Standard (100) Silizium mit einer <110> Orientierung des Flats. Die Kanten des Halbleiterchips verlaufen parallel und orthogonal zum Flat. Ein erstes Paar länglicher Widerstandsstreifen 27, die mit 0° und mit 90° zum Flat ausgerichtet sind, bildet den n-Typ Widerstand $R_2$, ein zweites Paar länglicher Widerstandsstreifen 28, die mit 0° und mit 90° zum Flat ausgerichtet sind, bildet den n-Typ Widerstand $R_3$. Die p-Typ Widerstände $R_1$ und $R_4$ sind aus mindestens einem Paar länglicher Widerstandsstreifen 29 bzw. 30 zusammengesetzt, die mit -45° und mit +45° zum Flat ausgerichtet sind und somit parallel zur <100> Kristallrichtung verlaufen. Die beiden Widerstandsstreifen eines jeden Paares sind gemäss dem Merkmal 4a ausgebildet, d.h. sie bilden zusammen einen L-förmigen Widerstand. Die Orientierung der n-Typ Widerstände parallel zu den <110> Kristallrichtungen verringert die Streuung der Widerstandswerte (engl. resistor mismatch), weil für n-Typ Silizium die Differenz $\pi_{11}$ - $\pi_{12}$ der Piezokoeffizienten $\pi_{11}$ und $\pi_{12}$ entlang der <110> Kristallachsen vergleichsweise klein ist. Die Orientierung der p-Typ Widerstände parallel zu den <100> Kristallrichtungen verringert die Streuung der Widerstandswerte, weil für p-Typ Silizium die Differenz $\pi_{11}$ - $\pi_{12}$ der Piezokoeffizienten $\pi_{11}$ und $\pi_{12}$ entlang der <100> Kristallachsen vergleichsweise klein ist. Um den Einfluss der durch die Widerstände $R_1$ bis $R_4$ fliessenden Ströme auf das Hallelement 15 zu minimieren, sind die acht Widerstandsstreifen 27 bis 30 der vier Widerstände $R_1$ bis $R_4$ so verdrahtet, dass der durch die Widerstandsstreifen 27 fliessende Strom im Gegenuhrzeigersinn, der durch die Widerstandsstreifen 28 fliessende Strom im Uhrzeigersinn, der durch die Widerstandsstreifen 29 fliessende Strom im Uhrzeigersinn und der durch die Widerstandsstreifen 30 fliessende Strom im Gegenuhrzeigersinn um das Hallelement 15 herum fliesst. Die Leiterbahnen, die die Widerstände $R_1$ bis $R_4$ miteinander verbinden, sind in der Fig. 12 nur der Vollständigkeit halber dargestellt, sie werden im Rahmen der technologischen Möglichkeiten so ausgeführt, dass der Strom, der durch sie fliesst, möglichst keinen Einfluss auf das Ausgangssignal des Hallelements 15 hat.

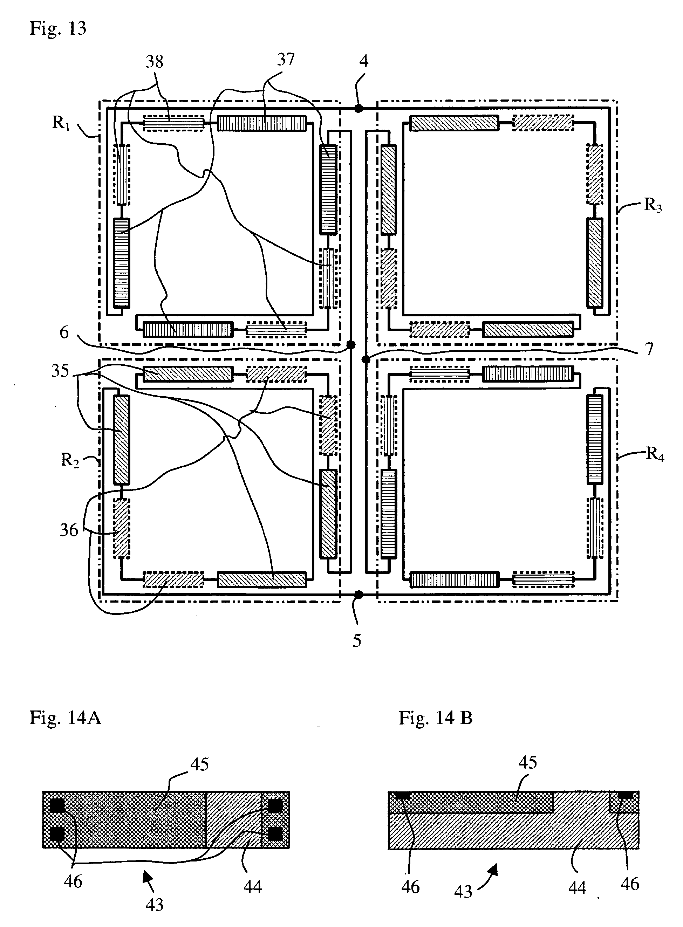

Die Fig. 13 zeigt ein weiteres Ausführungsbeispiel eines erfindungsgemässen Stresssensors 1, bei dem die vier Widerstände $R_1$ bis $R_4$ gemäss den Merkmalen 4a und 5c ausgebildet und in verschiedener Hinsicht optimiert sind. Für jeden der Widerstände $R_1$ bis $R_4$ gilt:

1. Jeder Widerstand besteht aus vier Widerstandsabschnitten, von denen zwei parallel zu einer ersten Richtung ausgerichtet sind, und von denen die beiden anderen parallel zu einer zweiten, zur ersten orthogonalen Richtung ausgerichtet sind.

2. Jeder der vier Widerstandsabschnitte besteht aus zwei in Reihe geschalteten Widerstandsstreifen, deren Dotierung unterschiedlich ist. Die für die n-Typ Widerstände $R_2$ und $R_3$ verwendeten Dotierungen sind eine hoch dotierte $N^+$ Dotierung, vorzugsweise die für die Herstellung der Kontakte verwendete $N^+$ Dotierung, für den ersten Widerstandsstreifen und eine mittlere N Dotierung, vorzugsweise die für die Herstellung der Wanne des Hallelementes verwendete Dotierung, d.h. die üblicherweise als n-well bezeichnete Dotierung, für den zweiten Widerstandsstreifen. Die für die p-Typ Widerstände $R_1$ und $R_4$ verwendeten Dotierungen sind eine hoch dotierte $P^+$ Dotierung, vorzugsweise die für die Herstellung der Kontakte verwendete $P^+$ Dotierung, für den ersten Widerstandsstreifen und eine mittlere P Dotierung, vorzugsweise die üblicherweise als p-well bezeichnete Dotierung, für den zweiten Widerstandsstreifen. Die Widerstandsstreifen mit der $N^+$ Dotierung sind mit dem Bezugzeichen 35, die Widerstandsstreifen mit der n-well Dotierung sind mit dem Bezugzeichen 36, die Widerstandsstreifen mit der $P^+$ Dotierung sind mit dem Bezugzeichen 37 und die Widerstandsstreifen mit der p-well Dotierung sind mit dem Bezugzeichen 38 bezeichnet. Gleichartige Widerstandsstreifen sind mit einer gleichen Umrandung und Schraffur dargestellt, weshalb aus Gründen der zeichnerischen Klarheit die Bezugzeichen der Widerstandsstreifen der Widerstände $R_3$ und $R_4$ weggelassen wurden. Der $N^+$ Widerstandsstreifen und der n-well Widerstandsstreifen weisen unterschiedliche Temperaturkoeffizienten auf, zudem weisen die piezo-resistiven Koeffizienten von hoch- und niedrigdotiertem Halbleitermaterial unterschiedliche Temperaturdriften auf. Das Verhältnis der Widerstandswerte des $N^+$ Widerstandsstreifens und des n-well Widerstandsstreifens eines jeden Widerstandsabschnittes ist so bemessen, dass die Temperaturdrift der stressabhängigen Widerstandsänderung gleich dem Piezo-Hall-Temperaturkoeffizienten ist. Dies wird im folgenden Beispiel verdeutlicht. Es bezeichnen

TC_$n^+$ den Temperaturkoeffizienten von $N^+$ Material
TC_$n_{well}$ den Temperaturkoeffizienten von $n_{well}$ Material
TC_$p^+$ den Temperaturkoeffizienten von $P^+$ Material
TC_$p_{well}$ den Temperaturkoeffizienten von $p_{well}$ Material
TC_$\pi n^+$ den piezo-resistiven Temperaturkoeffizienten von $N^+$ Material
TC_$\pi_{nwell}$ den piezo-resistiven Temperaturkoeffizienten von $n_{well}$ Material
TC_ph den piezo-Hall Temperaturkoeffizienten der Hall-Platte

$R\_N^+$ den Widerstand eines $N^+$ Widerstandsstreifens

$R\_n_{well}$ den Widerstand eines n-well Widerstandsstreifens

$R\_P^+$ den Widerstand eines $P^+$ Widerstandsstreifens

$R\_p_{well}$ den Widerstand eines p-well Widerstandsstreifens

$\alpha$, $\beta$, $\gamma$, $\eta$ Proportionalitätsparameter

Der Widerstand $R_n$ eines aus einem $N^+$ Widerstandsstreifen und einem n-well Widerstandsstreifen gebildeten Widerstandsabschnittes beträgt also

$$R_n = R\_N^+ + R\_n_{well}$$

Es sei nun

$$R\_N^+ = \alpha * R_n$$

$$R\_n_{well} = \beta * R_n$$

Dabei ist $\alpha + \beta = 1$. Das Verhältnis $\alpha / \beta$ wird durch die Gleichung

$$\alpha * TC\_\pi n^+ + \beta * TC\_\pi_{nwell} = TC\_ph$$

bestimmt, die beinhaltet, dass die Temperaturdrift der stressabhängigen Widerstandsänderung gleich dem Piezo-Hall-Temperaturkoeffizienten ist.

Ebenso weisen der $P^+$ Widerstandsstreifen und der p-well Widerstandsstreifen unterschiedliche Temperaturkoeffizienten auf. Das Verhältnis der Widerstandswerte des $P^+$ Widerstandsstreifens und des p-well Widerstandsstreifens eines jeden Widerstandsabschnittes ist so bemessen, dass die Temperaturdrift der stressunabhängigen Widerstandsänderung der p-Typ Widerstände $R_1$ und $R_4$ gleich gross ist wie die Temperaturdrift der stressunabhängigen Widerstandsänderung der n-Typ Widerstände $R_2$ und $R_3$, so dass der Temperaturkoeffizient des Ausgangssignals $V_w$ der durch die Widerstände $R_1$ bis $R_4$ gebildeten Wheatstone Brücke gleich null ist.

Der Widerstand $R_P$ eines aus einem $P^+$ Widerstandsstreifen und einem p-well Widerstandsstreifen gebildeten Widerstandsabschnittes beträgt also

$$R_p = R\_P^+ + R\_p_{well}$$

Es sei nun

$$R\_P^+ = \gamma * R_p$$

$$R\_p_{well} = \eta * R_p$$

Dabei ist $\gamma + \eta = 1$. Das Verhältnis $\gamma / \eta$ wird durch die Gleichung

$$\alpha * TC\_n^+ + \beta * TC\_n_{well} = \gamma * TC\_p^+ + \eta * TC\_p_{well}$$

bestimmt. Damit die aus den Widerstände $R_1$ bis $R_4$ gebildete Wheatstone Brücke offsetfrei ist, muss $R_P = R_n$ sein. Die so erhaltenen Werte für die Proportionalitätsparameter $\alpha$, $\beta$, $\gamma$ und $\eta$ sind Näherungswerte, die davon abhängen, wie genau die in den Gleichungen verwendeten Materialkonstanten bekannt sind, und bedürfen allenfalls einer experimentellen Korrektur.

3. Die acht Widerstandsstreifen eines Widerstands sind elektrisch so miteinander verbunden, dass

a) der Strom in entgegengesetzten Richtungen durch die beiden Widerstandsabschnitte fliesst, die die gleiche Orientierung aufweisen,

b) die Reihenfolge der Widerstandsabschnitte bezüglich ihrer Orientierung alternierend ist, d.h. Widerstandsabschnitt erster Orientierung, Widerstandsabschnitt zweiter Orientierung, Widerstandsabschnitt erster Orientierung und Widerstandsabschnitt zweiter Orientierung, oder umgekehrt,

c) die Reihenfolge der acht Widerstandsstreifen wie folgt ist:

$N^+$, n-well, n-well, $N^+$, $N^+$, n-well, n-well, $N^+$ bzw. $P^+$, p-well, p-well, $P^+$, $P^+$, p-well, p-well, $P^+$

Diese Massnahmen dienen dazu, die Streuung der Widerstandswerte $R_1$ bis $R_4$, die von Effekten unterschied-lichster Art herrühren, beispielsweise von Einflüssen der Raumladungszonen, von Einflüssen der Ionenimplantation, etc. zu minimieren.

Da der Einfluss der Temperaturdrift des piezo-resistiven Koeffizienten bei den p-Typ Widerständen $R_1$ und $R_4$ viel geringer ist als bei den n-Typ Widerständen $R_2$ und $R_3$, ist die Ausbildung der p-Typ Widerstandsabschnitte als zwei Widerstandsstreifen mit unterschiedlicher Dotierung nicht zwingend erforderlich, d.h. die p-Typ Widerstandsabschnitte können alternativ ein einziger $P^+$ Widerstandsstreifen sein.

Die Widerstände $R_1$ bis $R_4$ eines erfindungsgemässen Stresssensors 1 können im Rahmen der oben angeführten Merkmale und Ausführungsbeispiele auf beliebige Art kombiniert und auf vielfältige Art und Weise realisiert und auf dem Halbleiterchip 2 angeordnet werden und mit mindestens einem Hallelement zu einem stresskompensierten Hallsensor kombiniert werden. Um den Einfluss des Magnetfeldes, das von den durch die Widerstandsstreifen bzw. Widerstandsabschnitte fliessenden Strömen erzeugt wird, auf das mindestens eine Hallelement zu minimieren, sind die Widerstandsstreifen bzw. Widerstandsabschnitte mit Vorteil so angeordnet, dass der Strom bzw. die Ströme einmal im Uhrzeigersinn und einmal im Gegenuhrzeigersinn um das Hallelement herum fliesst.

Die Fig. 14A und B zeigen im Grundriss und Querschnitt ein Ausführungsbeispiel, bei dem die Widerstandsstreifen 35 und 36 eines n-Typ Widerstandsabschnittes der Fig. 13 kombiniert zu einem einzigen Widerstandsstreifen 43 ausgeführt sind. Der Widerstandsstreifen 43 besteht aus einer n-well 44, in die ein Streifen 45 $N^+$ Material integriert ist. Die Kontaktanschlüsse 46 sind wie üblich im $N^+$ Gebiet angeordnet. Ein Teil des Stroms fliesst somit durch $N^+$ Gebiet, ein anderer Teil durch n-well Gebiet. Die Widerstandsstreifen 37 und 38 eines p-Typ Widerstandsabschnittes der Fig. 13 können analog ausgeführt werden.

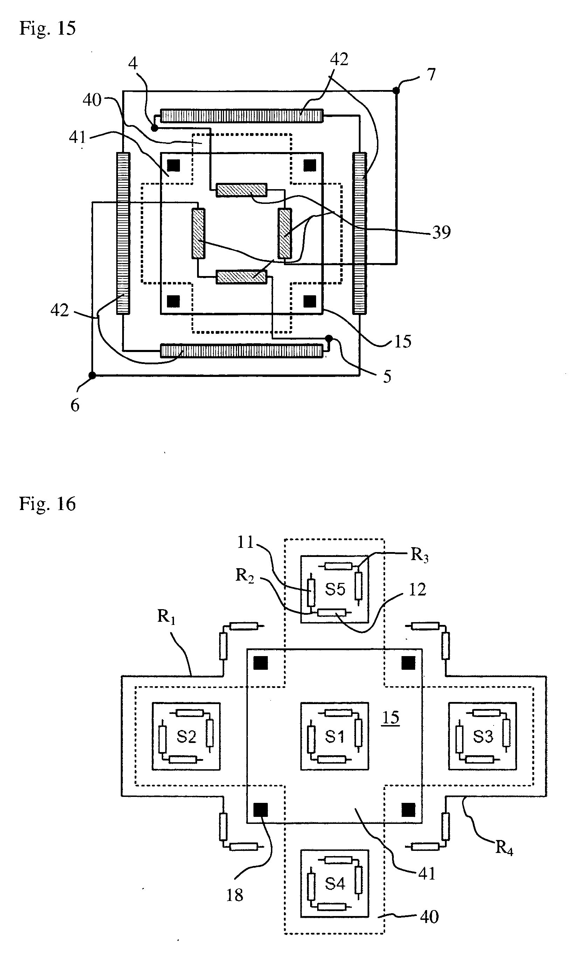

Die Fig. 15 zeigt ein weiteres Ausführungsbeispiel eines Hallsensors, der ein Hallelement 15 und einen erfindungsgemässen Stresssensor 1 umfasst. Bei diesem Ausführungsbeispiel bestehen die beiden n-Typ Widerstände $R_2$ und $R_3$ aus zwei orthogonal zueinander ausgerichteten $N^+$ Widerstandsstreifen 39, die in einer p-Wanne 40 angeordnet ist, die ihrerseits über der n-Wanne 41 des Hallelementes 15 angeordnet ist. Die p-Wanne 40 ist bei diesem Beispiel kreuzförmig, wobei die Arme des Kreuzes die n-Wanne 41 seitlich überragen. Die p-Typ Widerstände $R_1$ und $R_4$ bestehen aus zwei orthogonal zueinander ausgerichteten $P^+$ Widerstandsstreifen 42. Diese Ausführung ermöglicht die Messung des Stresses direkt am Ort des Hallelementes 15.

Bei allen Hallsensoren, die mindestens ein Hallelement und mindestens einen erfindungsgemässen Stresssensors umfassen, wird das Ausgangssignal der Wheatstone-Brücke des Stresssensors benutzt, um den Einfluss von Stress auf das Ausgangssignal des Hallelementes zu kompensieren, beispielsweise gemäss der in der Fig. 6 gezeigten Lösung. Das Ausgangssignal der Wheatstone-Brücke des Stresssensors kann aber auch digitalisiert und dann zur Kompensation des ebenfalls digitalisierten Ausgangssignals des Hallelementes verwendet werden.

Die Fig. 16 bis 18 zeigen je einen Hallsensor, der ein Hallelement 15 mit fünf bzw. neun integrierten Stresssensoren umfasst, die entsprechend mit S1 bis S5 bzw. S1 bis S9 bezeichnet sind. Jeder dieser Stresssensoren kann als Stresssensor nach einem der oben beschriebenen Ausführungsbeispiele ausgebildet sein, eine bevorzugte Ausführungsform ist in den Fig. 16 bis 18 dargestellt und wird hier näher erläutert. Die Stresssensoren S1 bis S5 bzw. S9 umfassen je eigene n-Typ Widerstände während die p-Typ Widerstände $R_1$ und $R_4$ allen gemeinsam sind und im Betrieb mittels nicht gezeigter Schalter jeweils entsprechend verbunden werden, um das Messsignal eines Stresssensors nach dem anderen aufzunehmen. Die n-Typ Widerstände $R_2$ und $R_3$ sind "L-förmige" Widerstände, die je mindestens zwei längliche Widerstandsstreifen 11 und 12 aufweisen, die den gleichen nominalen Widerstandswert aufweisen, zueinander um 90° verdreht und in Reihe geschaltet sind. Aus Gründen der zeichnerischen Klarheit sind die n-Typ Widerstände $R_2$ und $R_3$ nur beim Stresssensor S1 und die Widerstandsstreifen 11 und 12 nur beim Widerstand $R_2$ des Stresssensors S1 bezeichnet. Die n-Typ Widerstände sind wie bei dem in der Fig. 15 dargestellten Ausführungsbeispiel in eine p-Wanne 40 integriert, die in die n-Wanne 41 des Hallelementes eingebettet und vorzugsweise wie abgebildet kreuzförmig ist und die Hallkontakte 18 freilässt. Die p-Typ Widerstände $R_1$ und $R_4$ sind ebenfalls "L-förmige" Widerstände, die um das Hallelement 15 herum angeordnet sind. Die p-Typ Widerstände $R_1$ und $R_4$ bestehen bevorzugt wie dargestellt aus je mindestens vier länglichen, in Reihe geschalteten Widerstandsstreifen, die den gleichen nominalen Widerstandswert aufweisen, wobei jeweils zwei Widerstandsstreifen in Bezug zu den anderen zwei Widerstandsstreifen um 90° gedreht sind.

Die Stresssensoren sind kreuzförmig angeordnet, nämlich drei bzw. fünf Stresssensoren sind entlang der x-Achse und drei bzw. fünf Stresssensoren sind entlang der y-Achse angeordnet, wobei der Stresssensor S1 im Zentrum der beiden Achsen und im Zentrum des Hallelementes 15 angeordnet ist.

Der Verlauf der mechanischen Stresskomponente sigma = Txx+Tyy in Funktion des Ortes x bzw. des Ortes y kann dargestellt werden als

$$\text{sigma(x)} = A_0 + A_1 * x + ... + A_n * x^n$$

$$\text{sigma(y)} = B_0 + B_1 * x + ... + B_n * x^n$$

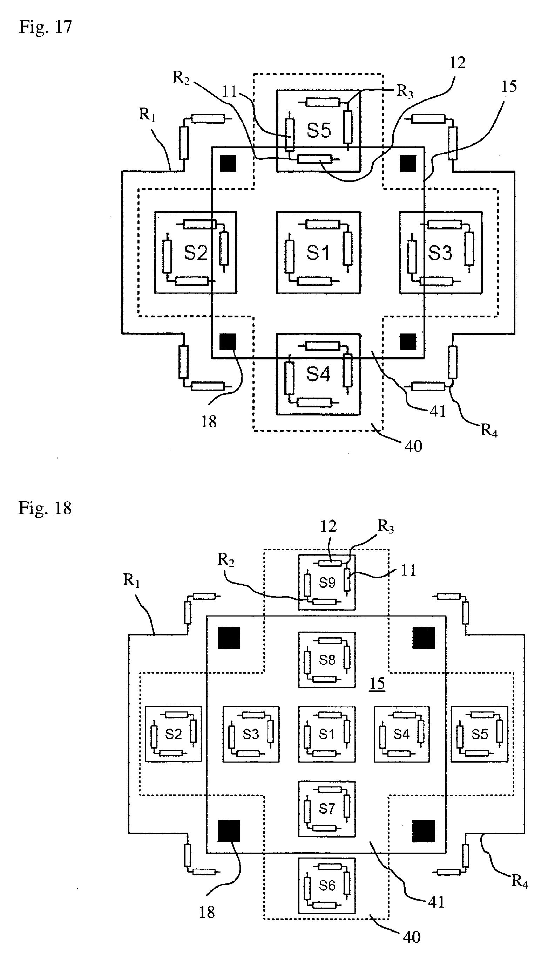

Im Betrieb des Hallsensors werden aus den Ausgangssignalen der entlang der x-Achse angeordneten Stresssensoren und der entlang der y-Achse angeordneten Stresssensoren mittels üblicher mathematischer Methoden die Koeffizienten $A_0$ bis $A_n$ und $B_0$ bis $B_n$ bis zur n. Ordnung bestimmt. Die Ordnung n ist bei den Ausführungsformen der Fig. 16 und 17 maximal 2, bei der Ausführungsform der Fig. 18 maximal 4.

Die Koeffizienten $A_0$ bis $A_n$ und $B_0$ bis $B_n$ werden mit Gewichtsfaktoren $k_0$ bis $k_m$ multipliziert und dann addiert, um ein Stresssignal $V_s$ zu bilden:

$$V_S = k_0 * A_0 + k_1 * A_1 + k_2 * A_2 + ... + k_{m/2} * A_n + k_{m/2+1} * B_0 + ... + k_{m-1} * B_{n-1} + k_m * B_n$$

Der Hallstrom durch das Hallelement 15 wird dann bevorzugt gemäss der Gleichung (6) stresskompensiert.

**Patentansprüche**

1. Stresssensor (1) zur Erfassung mechanischer Spannungen in einem Halbleiterchip (2), wobei der Stresssensor in eine aktive Oberfläche (3) des Halbleiterchips (2) integrierte Widerstände aufweist, wobei die integrierten Widerstände vier integrierte Widerstände $R_1$ bis $R_4$ umfassen, die eine Wheatstone Brücke bilden, bei der die Widerstände $R_1$ und $R_2$ in Reihe geschaltet, die Widerstände $R_3$ und $R_4$ in Reihe und parallel zu den Widerständen $R_1$ und $R_2$ geschaltet sind, wobei die Widerstände $R_1$ und $R_3$ einen gemeinsamen Knoten (4) und die Widerstände $R_2$ und $R_4$ einen gemeinsamen Knoten (5) haben, und wobei die Widerstände $R_1$ und $R_4$ p-Typ Widerstände und die Widerstände $R_2$ und $R_3$ n-Typ Widerstände sind, **dadurch gekennzeichnet, dass** jeder der n-Typ Widerstände $R_2$ und $R_3$ aus länglichen Widerstandsabschnitten (13.1 bis 13.5) besteht, die direkt oder über elektrische Leiter miteinander verbunden sind, wobei jeder der Widerstandsabschnitte (13.1 bis 13.5) in der durch die aktive Oberfläche (3) des Halbleiterchips (2) definierten Ebene (xy) eine vorbestimmte Orientierung aufweist, wobei eine Summe der Widerstandswerte aller Widerstandsabschnitte, die eine erste Orientierung aufweisen und zum gleichen Widerstand $R_2$ bzw. $R_3$ gehören, und eine Summe der Widerstandswerte aller Widerstandsabschnitte, die eine zweite, zur ersten um 90° gedrehte Orientierung aufweisen und ebenfalls zum gleichen Widerstand $R_2$ bzw. $R_3$ gehören, den gleichen nominalen Wert haben.

2. Stresssensor (1) nach Anspruch 1, **dadurch gekennzeichnet, dass** jeder der p-Typ Widerstände $R_1$ und $R_4$ aus länglichen Widerstandsabschnitten (13.1 bis 13.5) besteht, die direkt oder über elektrische Leiter miteinander verbunden sind, wobei jeder der Widerstandsabschnitte (13.1 bis 13.5) in der durch die aktive Oberfläche (3) des Halbleiterchips (2) definierten Ebene (xy) eine vorbestimmte Orientierung aufweist, wobei eine Summe der Widerstandswerte aller Widerstandsabschnitte, die eine erste Orientierung aufweisen und zum gleichen Widerstand $R_1$ bzw. $R_4$ gehören, und eine Summe der Widerstandswerte aller Widerstandsabschnitte, die eine zweite, zur ersten um 90° gedrehte Orientierung aufweisen und ebenfalls zum gleichen Widerstand $R_1$ bzw. $R_4$ gehören, den gleichen nominalen Wert haben.

3. Stresssensor (1) nach Anspruch 2, **dadurch gekennzeichnet, dass** die Widerstandsabschnitte der n-Typ Widerstände $R_2$ und $R_3$ und die Widerstandsabschnitte der p-Typ Widerstände $R_1$ und $R_4$ einen Winkel von 45° oder -45° einschliessen.

4. Stresssensor (1) nach Anspruch 2, **dadurch gekennzeichnet, dass** das Grundmaterial (100) Silizium ist, dass die Kanten des Halbleiterchips (2) parallel und orthogonal zur <110> Kristallrichtung verlaufen, dass die Widerstandsabschnitte der n-Typ Widerstände $R_2$ und $R_3$ parallel oder orthogonal zur <110> Kristallrichtung und die Widerstandsabschnitte der p-Typ Widerstände $R_1$ und $R_4$ parallel oder orthogonal zur <100> Kristallrichtung verlaufen.

5. Stresssensor (1) nach einem der Ansprüche 1 bis 4, **dadurch gekennzeichnet, dass** die n-Typ Widerstände $R_2$ und $R_3$ vergleichsweise hoch dotiertes und vergleichsweise niedriger dotiertes Halbleitermaterial umfassen, die so kombiniert sind, dass die Temperaturdrift der stressabhängigen Widerstandsänderung der n-Typ Widerstände $R_2$ und $R_3$ gleich dem Piezo-Hall-Temperaturkoeffizienten ist.

6. Stresssensor (1) nach Anspruch 5, **dadurch gekennzeichnet, dass** die p-Typ Widerstände $R_1$ und $R_4$ vergleichsweise hoch dotiertes und vergleichsweise niedriger dotiertes Halbleitermaterial umfassen, welche Halbleitermaterialen so kombiniert sind, dass die Temperaturdrift der stressunabhängigen Widerstandsänderung der p-Typ Widerstände $R_1$ und $R_4$ gleich gross ist wie die Temperaturdrift der stressunabhängigen Widerstandsänderung der n-Typ Widerstände $R_2$ und $R_3$.

7. Hallsensor, umfassend mindestens ein Hallelement (15) und mindestens einen Stresssensor (1) nach einem der Ansprüche 1 bis 6, wobei das Ausgangssignal des mindestens einen Stresssensors benutzt wird, um das Ausgangssignal des mindestens einen Hallelementes (15) zu stresskompensieren.

8. Hallsensor nach Anspruch 7, **gekennzeichnet durch** mindestens zwei Stromquellen (21, 22, 23, 24) für die Beaufschlagung des mindestens einen Hallelementes (15) mit einem Strom, wobei ein Ausgangssignal des Stresssensors (1) eine der mindestens zwei Stromquellen steuert.

9. Hallsensor nach Anspruch 7 oder 8, **dadurch gekennzeichnet, dass** mindestens fünf Stresssensoren (1) vorhanden sind, die entlang von zwei orthogonal zueinander verlaufenden Achsen angeordnet sind, und dass aus den Ausgangssignalen der Stresssensoren ein einziges Ausgangssignal gebildet wird, um das Ausgangssignal des mindestens einen Hallelementes (15) zu stresskompensieren.

**Claims**

1. Stress sensor (1) for detecting mechanical stresses in a semiconductor chip (2), the stress sensor having resistors integrated in an active surface (3) of the semiconductor chip (2), wherein the integrated resistors comprise four integrated resistors $R_1$ to $R_4$, which form a Wheatstone bridge, in which the resistors $R_1$ and $R_2$ are connected in series, the resistors $R_3$ and $R_4$ are connected in series and in parallel to the resistors $R_1$ and $R_2$, wherein the resistors $R_1$ and $R_3$ have a common node (4) and the resistors $R_2$ and $R_4$ have a common node (5), and wherein the resistors $R_1$ and $R_4$ are p-type resistors and the resistors $R_2$ and $R_3$ are n-type resistors, **characterized in that** each of the n-type resistors $R_2$ and $R_3$ consists of oblong resistor sections (13.1 to 13.5), which are connected to one another directly or via electrical conductors, wherein each of the resistor sections (13.1 to 13.5) has a predetermined orientation in the plane (xy) defined by the active surface (3) of the semiconductor chip (2), wherein a sum of the resistance values of all resistor sections which have a first orientation and belong to the same resistor $R_2$ or $R_3$, and a sum of the resistance values of all resistor sections which have a second orientation rotated by 90° to the first orientation and also belong to the same resistor $R_2$ or $R_3$, have the same nominal value.

2. Stress sensor (1) according to claim 1, **characterized in that** each of the p-type resistors $R_1$ and $R_4$ consists of oblong resistor sections (13.1 to 13.5), which are connected to one another directly or via electrical conductors, wherein each of the resistor sections (13.1 to 13.5) has a predetermined orientation in the plane (xy) defined by the active surface (3) of the semiconductor chip (2), wherein a sum of the resistance values of all resistor sections which have a first orientation and belong to the same resistor $R_1$ or $R_4$, and a sum of the resistance values of all resistor sections which have a second orientation rotated by 90° to the first orientation and also belong to the same resistor $R_1$ or $R_4$, have the same nominal value.

3. Stress sensor (1) according to claim 2, **characterized in that** the resistor sections of the n-type resistors $R_2$ and $R_3$ and the resistor sections of the p-type resistors $R_1$ and $R_4$ enclose an angle of 45° or -45 °.

4. Stress sensor (1) according to claim 2, **characterized in that** the base material (100) is silicon, that the edges of the semiconductor chip (2) extend parallel and orthogonal to the <110> crystal direction, that the resistor sections of the n-type resistors $R_2$ and $R_3$ extend parallel or orthogonal to the <110> crystal direction, and that the resistor sections of the p-type resistors $R_1$ and $R_4$ extend parallel or orthogonal to the <100> crystal direction.

5. Stress sensor (1) according to any of claims 1 to 4, **characterized in that** the n-type resistors $R_2$ and $R_3$ comprise comparatively heavily doped and comparatively lightly doped semiconductor material, which are combined so that the temperature drift of the stress-dependent resistance change of the n-type resistors $R_2$ and $R_3$ is equal to the piezo-Hall temperature coefficient.

6. Stress sensor (1) according to claim 5, **characterized in that** the p-type resistors $R_1$ and $R_4$ comprise comparatively heavily doped and comparatively lightly doped semiconductor material, these semiconductor materials being combined so that the temperature drift of the stress-independent resistance change of the p-type resistors $R_1$ and $R_4$ is equal to the temperature drift of the stress-independent resistance change of the n-type resistors $R_2$ and $R_3$.

7. Hall sensor, comprising at least one Hall element (15) and at least one stress sensor (1) according to any of claims 1 to 6, wherein the output signal of the at least one stress sensor is used to stress-compensate the output signal of the at least one Hall element (15).

8. Hall sensor according to claim 7, **characterized by** at least two current sources (21, 22, 23, 24) for applying a current to the at least one Hall element (15), wherein an output signal of the stress sensor (1) controls one of the at least two current sources.

9. Hall sensor according to claim 7 or 8, **characterized in that** at least five stress sensors are provided, which are arranged along two axes extending orthogonally to one another, and that a single output signal is formed from the output signals of the stress sensors, in order to stress-compensate the output signal of the at least one Hall element (15).

**Revendications**

1. Capteur de contraintes mécaniques (1) pour la détection de tensions mécaniques dans une puce de semi-conducteur (2), lequel capteur de contraintes ayant des résistances intégrées dans une surface active (3) de la puce de semi-conducteur (2), les résistance intégrées comprenant quatre résistances intégrées $R_1$ à $R_4$ qui forment un pont de Wheatstone, dans lequel les résistances $R_1$ et $R_2$ sont montées en série, les résistances $R_3$ et $R_4$ sont montées en série et en parallèle avec les résistances $R_1$ et $R_2$, les résistances $R_1$ et $R_3$ possédant un noeud (4) commun et les résistances $R_2$ et $R_4$ possédant un noeud (5) commun, et les résistances $R_1$ et $R_4$ étant des résistances de type p et les résistances $R_2$ et $R_3$ des résistances de type n, **caractérisé en ce que** chacune des résistances de type n $R_2$ et $R_3$ se compose de segments de résistance oblongues (13.1 à 13.5) qui sont reliés entre eux directement ou par des conducteurs électriques, chacun des segments de résistance (13.1 à 13.5) ayant une orientation prédéterminée dans le plan (xy) défini par la surface active (3) de la puce de semi-conducteur (2), une somme des valeurs de résistance de tous les segments de résistance qui présentent une première orientation et appartiennent à la même résistance $R_2$ ou $R_3$ et une somme des valeurs de résistance de tous les segments de résistance qui présentent une deuxième orientation tournée de 90° par rapport à la première orientation et qui appartiennent également à la même résistance $R_2$ ou $R_3$ ayant la même valeur nominale.

2. Capteur de contraintes mécaniques (1) selon la revendication 1, **caractérisé en ce que** chacune des résistances de type p $R_1$ et $R_4$ se compose de segments de résistance oblongues (13. 1 à 13.5) qui sont reliés entre eux directement ou par des conducteurs électriques, chacun des segments de résistance (13.1 à 13.5) ayant une orientation prédéterminée dans le plan (xy) défini par la surface active (3) de la puce de semi-conducteur (2), une somme des valeurs de résistance de tous les segments de résistance qui présentent une première orientation et appartiennent à la même résistance $R_1$ ou $R_4$ et une somme des valeurs de résistance de tous les segments de résistance qui ont une deuxième orientation tournée de 90° par rapport à la première orientation et qui appartiennent également à la même résistance $R_1$ ou $R_4$ ayant la même valeur nominale.

3. Capteur de contraintes mécaniques (1) selon la revendication 2, **caractérisé en ce que** les segments de résistance des résistances de type n $R_2$ et $R_3$ et les segments de résistance des résistances de type p $R_1$ et $R_4$ incluent un angle de 45° ou -45°.

4. Capteur de contraintes mécaniques (1) selon la revendication 2, **caractérisé en ce que** le matériau de base (100) est du silicium, **en ce que** les bords de la puce de semi-conducteur (2) sont parallèles et perpendiculaires à la direction <110> du cristal, **en ce que** les segments de résistance des résistances de type n $R_2$ et $R_3$ sont parallèles ou perpendiculaires à la direction <110> du cristal et les segments de résistance des résistances de type p $R_1$ et $R_4$ sont parallèles ou perpendiculaires à la direction <100> du cristal.

5. Capteur de contraintes mécaniques (1) selon l'une des revendications 1 à 4, **caractérisé en ce que** les résistances de type n $R_2$ et $R_3$ comprennent un matériau semi-conducteur relativement fortement dopé et relativement moins dopé, qui sont combinés de telle manière que la dérive de température du changement de résistance en fonction des contraintes des résistances de type n $R_2$ et $R_3$ soit égale au coefficient de température de l'effet piézo-Hall.

6. Capteur de contraintes mécaniques (1) selon la revendication 5, **caractérisé en ce que** les résistances de type p $R_1$ et $R_4$ comprennent un matériau semi-conducteur relativement fortement dopé et relativement moins dopé, lesquels matériaux semi-conducteurs sont combinés de telle manière que la dérive en température du changement de résistance indépendante des contraintes des résistances de type p $R_1$ et $R_4$ soit égale à la dérive en température du changement de résistance indépendante des contraintes des résistances de type n $R_2$ et $R_3$.

7. Capteur à effet Hall comprenant au moins un élément à effet Hall (15) et au moins un capteur de contraintes mécaniques (1) selon l'une des revendications 1 à 6, dans lequel le signal de sortie d'au moins un capteur de contraintes est utilisé pour compenser les contraintes dans le signal de sortie d'au moins un élément à effet Hall (15).

8. Capteur à effet Hall selon la revendication 7, **caractérisé en ce qu'**il comporte au moins deux sources de courant (21, 22, 23, 24) pour appliquer un courant à l'au moins un élément à effet Hall (15), un signal de sortie du capteur de contraintes (1) contrôlant l'une des au moins deux sources de courant.

9. Capteur à effet Hall selon la revendication 7 ou 8, **caractérisé en ce qu'**il est prévu au moins cinq capteurs de contraintes (1) disposés le long de deux axes perpendiculaires l'un à l'autre, et **en ce qu'**un seul signal de sortie est constitué à partir des signaux de sortie des capteurs de contraintes pour compenser les contraintes dans le signal de sortie d'au moins un élément à effet Hall (15).

Fig. 1

Fig. 2

Fig. 3A

Fig. 3B

Fig. 3C

Fig. 3D

Fig. 4

Fig. 5

Fig. 6

Fig. 7

Fig. 8

Fig. 9

Fig. 10

Fig. 11

Fig. 12

Fig. 13

Fig. 14A

Fig. 14 B

Fig. 15

Fig. 16

Fig. 17

Fig. 18

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0118556 A
- EP 548391 A
- DE 4302342
- DE 10154495
- DE 10154498
- DE 102004003853
- DE 102008051949
- DE 102006045141
- US 2006043508 A